# EUROPEAN PATENT APPLICATION

(11) **EP 2 369 718 A2**
(43) Date of publication of application: **28.09.2011**
(21) Application number: 11159356.2
(22) Date of filing: 23.03.2011
(51) Int. Cl.: H02J 13/00

(54) **Power line maintenance monitoring**

(30) Priority: 23.03.2010 US 729319
(71) Applicant: Southwire Company, Carrollton, GA 30119-4400 (US)
(72) Inventor: Lancaster, Mark, Brooks, GA 30205 (US)
(74) Representative: Ström & Gulliksson AB

(57) **Abstract**

Maintenance monitoring may be provided. First, a plurality of status data respectively corresponding to a plurality of components on a power line may be collected. Then the collected plurality of status data may be analyzed to determine when a one of the collected plurality of status data is outside of a normal operation range for a one of the plurality of components corresponding to the one of the collected plurality of status data. Next, results of the collected data analysis may be displayed. The results may indicate that the one of the collected plurality of status data is outside of the normal operation range for the one of the plurality of components corresponding to the one of the collected plurality of status data.

## Description

### COPYRIGHTS

All rights, including copyrights, in the material included herein are vested in and the property of the Applicants. The Applicants retain and reserve all rights in the material included herein, and grant permission to reproduce the material only in connection with reproduction of the granted patent and for no other purpose.

### BACKGROUND

A power line is a system of many components. These components include conductors, splices, dead-ends, insulators, and structures. Power line monitoring and inspection has conventionally been done manually on a scheduled basis. This requires a utility company crew with equipment to visit each structure on the power line to visually inspect the components. Additionally, some utility companies use a helicopter to "fly" the power line and perform a visual and thermal inspection. Generally a utility company will determine an inspection schedule, attempting to balance cost of the inspection verses cost of repairing the failure and service interruption. With conventional power line monitoring and inspection, however, potential component failure points may go undetected, especially if the inspections occur when the power line is lightly loaded. Accordingly, conventional power line monitoring and inspection is time consuming, expensive, prone to inaccuracy, and components can fail between extended inspection cycles.

### SUMMARY

This Summary is provided to introduce a selection of concepts in a simplified form that are further described below in the Detailed Description. This Summary is not intended to identify key features or essential features of the claimed subject matter. Nor is this Summary intended to be used to limit the claimed subject matter's scope.

Maintenance monitoring may be provided. First, a plurality of status data respectively corresponding to a plurality of components on a power line may be collected. Then the collected plurality of status data may be analyzed to determine when a one of the collected plurality of status data is outside of a normal operation range for a one of the plurality of components corresponding to the one of the collected plurality of status data. Next, results of the collected data analysis may be displayed. The results may indicate that the one of the collected plurality of status data is outside of the normal operation range for the one of the plurality of components corresponding to the one of the collected plurality of status data.

Both the foregoing general description and the following detailed description provide examples and are explanatory only. Accordingly, the foregoing general description and the following detailed description should not be considered to be restrictive. Further, features or variations may be provided in addition to those set forth herein. For example, embodiments may be directed to various feature combinations and sub-combinations described in the detailed description.

### BRIEF DESCRIPTION OF THE DRAWINGS

The accompanying drawings, which are incorporated in and constitute a part of this disclosure, illustrate various embodiments of the present invention. In the drawings:

FIG. 1 shows an operating environment;

FIG. 2 shows a power line monitor;

FIG. 3 shows an operating environment for the power line monitor;

FIG. 4 shows a SCADA system; and

FIG. 5 is a flow chart of a method for providing maintenance monitoring.

### DETAILED DESCRIPTION

The following detailed description refers to the accompanying drawings. Wherever possible, the same reference numbers are used in the drawings and the following description to refer to the same or similar elements. While embodiments of the invention may be described, modifications, adaptations, and other implementations are possible. For example, substitutions, additions, or modifications may be made to the elements illustrated in the drawings, and the methods described herein may be modified by substituting, reordering, or adding stages to the disclosed methods. Accordingly, the following detailed description does not limit the invention.

Electric power lines are systems of many components. These components comprise, but are not limited to, conductors, conductor splices, conductor dead-ends, insulators, strings of insulators (i.e. insulator strings,) insulator string supports, structures, and structure grounds. Utility companies may manually inspect these components on a scheduled basis. These manual inspections are time consuming, expensive, prone to inaccuracy, and components may fail between extended manual inspection cycles.

Consistent with embodiments of the invention, a real-time power line maintenance monitoring system may provide a utility company with information on the status of a power line, the interpretation of this information, and display of this information in a manner that may allow the utility company to optimize the operation and maintenance of the power line. This may allow for increased power line reliability as the utility company may be able to determine if the power line is approaching its clearance limit or if a monitored component is failing. Embodiments of the invention may allow "continuous" monitoring of power line components. This continuous monitoring may reduce inspection expenses over conventional manual processes and provide earlier indication of potential component failure.

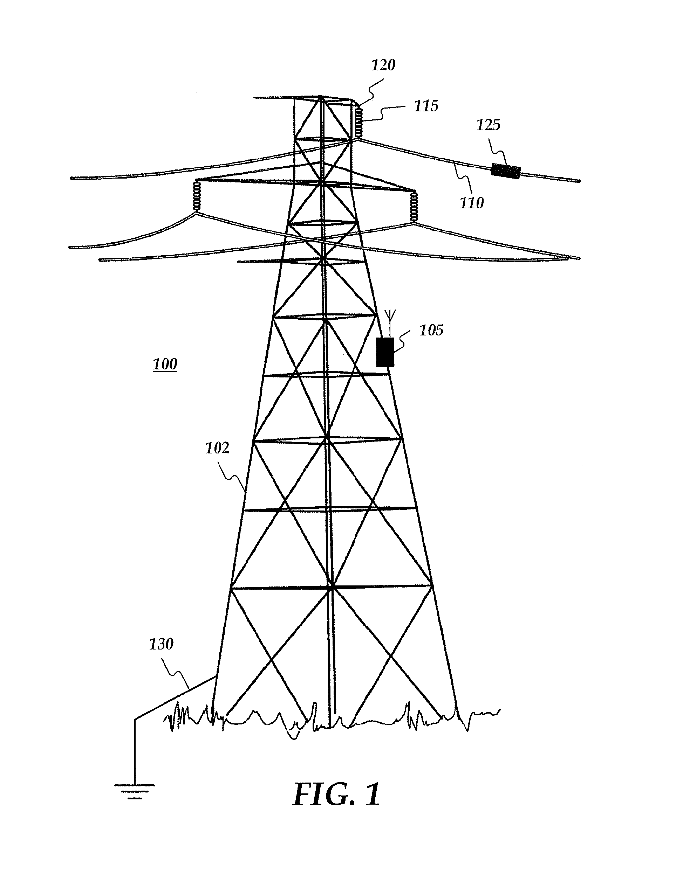

FIG. 1 shows an operating environment 100 used to transmit or deliver electrical power. As shown in FIG. 1, operating environment 100 may include a structure 102, a power line monitor 105, a conductor 110, an insulator string 115, an insulator string support 120, a conductor splice 125, and a structure ground 130. Structure 102 may support conductor 110. While structure 102 is shown in FIG. 1 as a galvanized steel lattice tower, structure 102 may comprise any structure configured to support conductor 110 such as a steel pole structure, a wooden pole structure, or a structure made of any material configured in any way.

Conductor 110 may comprise any type conductor used to transmit electric power such as, but not limited to, Aluminum Conductor Steel Reinforced (ACSR). Conductor splice 125 may comprise any component configured to splice conductor 110. Insulator string 115 may comprise any component configured to insulate conductor 110 from structure 102. Insulator string support 120 many comprise any component configured to attach insulator string 115 to structure 102. Structure ground 130 may comprise any component that grounds structure 102 to the Earth, for example, a grounding rod(s) and a connector.

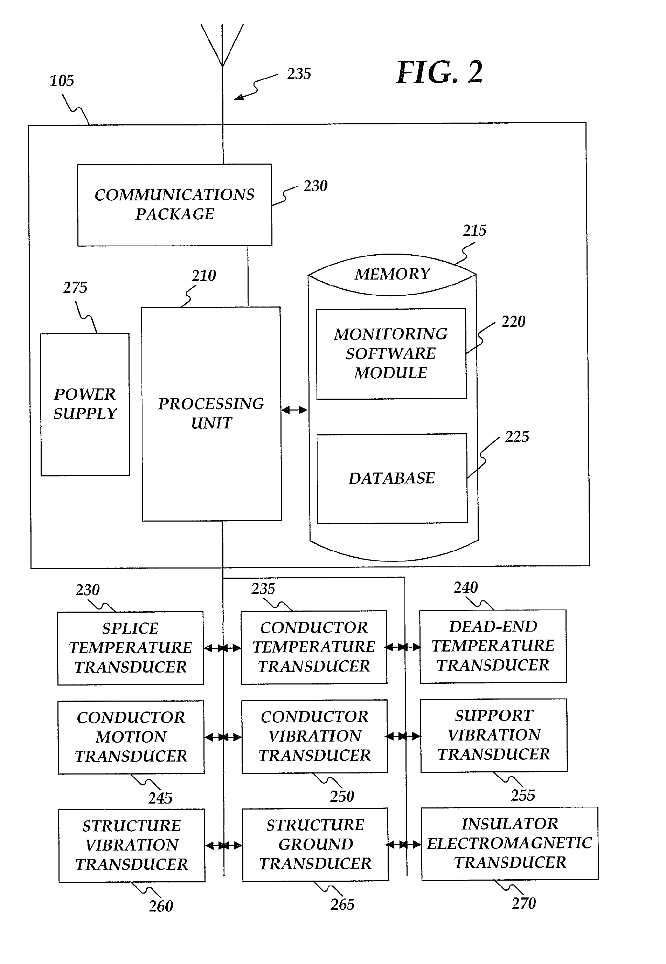

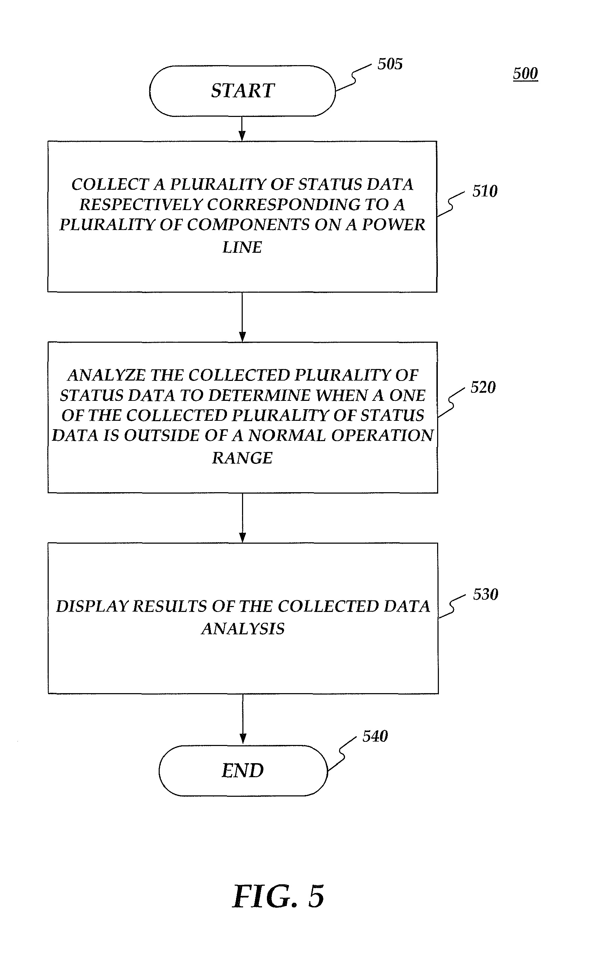

FIG. 2 shows power line monitor 105 in more detail. As shown in FIG. 2, power line monitor 105 may include a processing unit 210 and a memory 215. Memory 215 may include a monitoring software module 220 and a database 225. While executing on processing unit 210, monitoring software module 220 may perform processes for providing maintenance monitoring including, but not limited to, one or more of the stages of a method 500 as described below in greater detail with respect to FIG. 5.

Power line monitor 105 may also include a communications package 230 that may include and antenna 235 and may be connected to processing unit 210. Communications package 230 may transmit status data collected from power line monitor 105 and may receive other data including control data. Communications package 230 may communicate over a network (not shown). The network may comprise, for example, a local area network (LAN) or a wide area network (WAN). When a LAN is used as the network, a network interface located at power line monitor 105 may be used to interconnect any other processor on the network. When the network is implemented in a WAN networking environment, such as the Internet, power line monitor 105 may include an internal or external modem (not shown) or other means for establishing communications over the WAN. Further, in utilizing the network, data sent over the network may be encrypted to insure data security by using encryption/decryption techniques.

In addition to utilizing a wire line communications system, a wireless communications system, or a combination of wire line and wireless may be utilized as the network. Wireless may be defined as radio transmission via the airwaves. However, it may be appreciated that various other communication techniques can be used to provide wireless transmission, including infrared line of sight, cellular, microwave, satellite, packet radio, and spread spectrum radio. For example, power line monitor 105 may communicate across a wireless interface such as, for example, a cellular interface (e.g., general packet radio system (GPRS), enhanced data rates for global evolution (EDGE), global system for mobile communications (GSM)), a wireless local area network interface (e.g., WLAN, IEEE 802), a bluetooth interface, WiFi, WiMax, another RF communication interface, and/or an optical interface. Furthermore, power line monitor 105 may communicate over a power line carrier system.

Power line monitor 105 may communicate with a plurality of status transducers. The status transducers may include, but are not limited to, a splice temperature transducer 230, a conductor temperature transducer 235, a dead-end temperature transducer 240, a conductor motion transducer 245, a conductor vibration transducer 250, a support vibration transducer 255, a structure vibration transducer 260, a structure ground transducer 265, and an insulator breakdown transducer 270, an ambient air temperature transducer (not shown), all of which may collect and communicate status data to processing unit 210. The status transducers may communicate with processing unit 210 in any way. For example, the status transducers may communicate with processing unit 210 either over a wire or wirelessly, directly or through the network, for example.

All elements within power line monitor 105 may be supplied with power from a power supply 275. Because power line monitor 105 may be in close proximity to a power line (e.g. coupled to the power line,) power supply 275 may scavenge power from the power line using a current transformer (CT,) for example. Power supply 275 may also be a solar power supply.

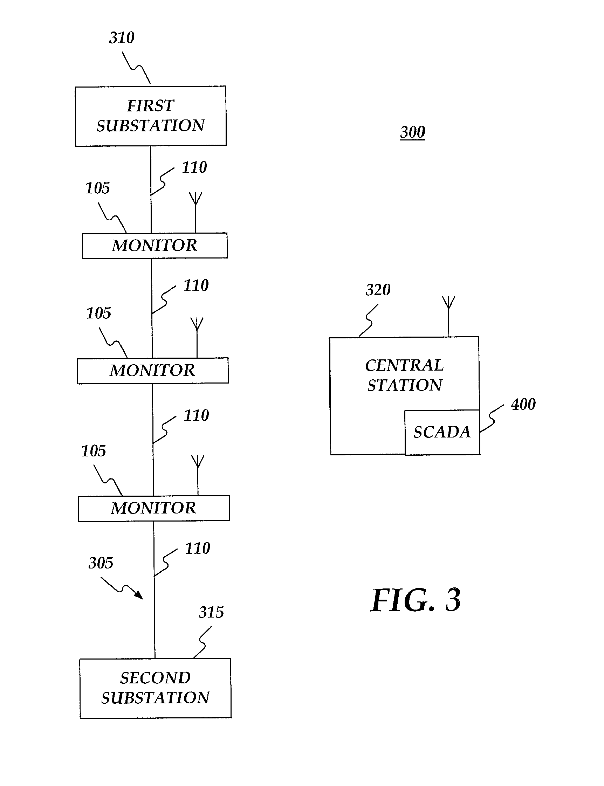

FIG. 3 shows an operating environment 300 for power line monitor 105 consistent with embodiments of the invention. As shown in FIG. 3, a power line 305 (e.g. including conductor 110) may connect a first substation 310 and a second substation 315. Power line 305 may be tens or even hundreds of miles long. RUS BULLETIN 1724E-200, "DESIGN MANUAL FOR HIGH VOLTAGE TRANSMISSION LINES", published by the Electric Staff Division, Rural Utilities Service, U.S. Department of Agriculture shows how power lines may be designed.

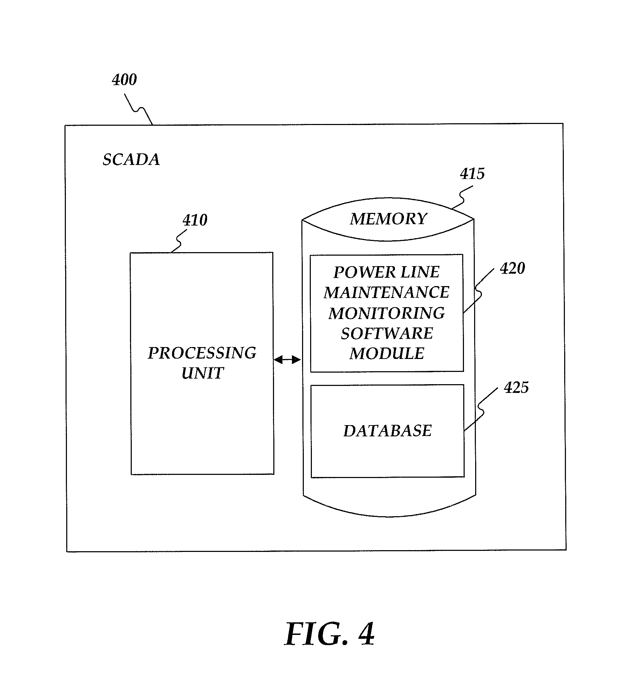

Any number of sensor devices 105 may be placed on power line 305. Sensor devices 105 in environment 300 may include any one or more of a combination of the status transducers shown in FIG. 2. Each of the sensor devices 105 may collect status data at a location (e.g. structure) where the sensor device is located on power line 305. After collection, each of the sensor devices 105 may transmit its collected status data to a central station 320. At central station 320, the received status data may be fed into a supervisory control and data acquisition (SCADA) system 400 as shown in more detail in FIG. 4.

FIG. 4 shows SCADA system 400 in more detail. As shown in FIG. 4, SCADA system 400 may include a processing unit 410 and a memory 415. Memory 415 may include a power line maintenance monitoring software module 420 and a database 425. While executing on processing unit 410, power line maintenance monitoring software module 420 may perform, for example, processes for providing maintenance monitoring including, for example, any one or more of the stages of method 500 as described in greater detail below with respect to FIG. 5.

FIG. 5 is a flow chart setting forth the general stages involved in a method 500 consistent with embodiments of the invention for providing maintenance monitoring. Method 500 may be implemented using power line monitor 105, SCADA system 400, or a combination of both power line monitor 105 and SCADA system 400. Ways to implement the stages of method 500 will be described in greater detail below.

Method 500 may begin at starting block 505 and proceed to stage 510 where power line monitor 105 may collect a plurality of status data respectively corresponding to a plurality of components on a power line. For example, the plurality of components may comprise, but are not limited to, a conductor dead-end, structure 102, conductor 110, insulator string 115, insulator string support 120, conductor splice 125, and structure ground 130.

Conductor temperature transducer 235 may be placed at or near conductor 110, may be configured to measure the temperature of conductor 110, and send the measured conductor temperature reading back to power line monitor 105. Splice temperature transducer 230 may be placed at or near conductor splice 125, be configured to measure the temperature of conductor splice 125, and send the measured splice temperature reading back to power line monitor 105. Dead-end temperature transducer 240 may be placed at or near a conductor dead-end (not shown), be configured to measure the temperature of the conductor dead-end, and send the measured dead-end temperature reading back to power line monitor 105.

Conductor motion transducer 245 may comprise, for example, an accelerometer and may be placed on conductor 110, for example, at or near mid-span. Conductor motion transducer 245 may be configured to measure the motion (e.g. movement profile) of conductor 110 and send the measured motion measurements back to power line monitor 105. The motion measurements may be used to determine if conductor 110 is in a "galloping" state. Conductor galloping is described in RUS BULLETIN 1724E-200, "DESIGN MANUAL FOR HIGH VOLTAGE TRANSMISSION LINES", published by the Electric Staff Division, Rural Utilities Service, U.S. Department of Agriculture and is incorporated herein by reference.

Conductor vibration transducer 250 may be placed on conductor 110. Conductor vibration transducer 250 may be configured to measure the vibration of conductor 110 and send the vibration measurements (e.g. vibration profile) back to power line monitor 105. The vibration measurements may be used to determine if conductor 110 is experiencing excessive Aeolian vibration (e.g. torsional conductor movement and string vibration) which can lead to conductor fatigue failures. Aeolian vibration is described in RUS BULLETIN 1724E-200, "DESIGN MANUAL FOR HIGH VOLTAGE TRANSMISSION LINES", published by the Electric Staff Division, Rural Utilities Service, U.S. Department of Agriculture and is incorporated herein by reference.

Support vibration transducer 255 may be placed at or near insulator string support 120, be configured to measure vibration of insulator string support 120, and send the measured vibration reading (e.g. vibration profile) of insulator string support 120 back to power line monitor 105. Moreover, support vibration transducer 255 may be configured to "ping" insulator string support 120 with a mechanical energy wave and measure the reflection of the mechanical energy wave in insulator string support 120 as the measured vibration reading.

Structure vibration transducer 260 may be placed on or near structure 102, be configured to measure vibration of structure 102, and send the measured vibration reading (e.g. vibration profile) back to power line monitor 105. Moreover, structure vibration transducer 260 may be configured to "ping" structure 102 with a mechanical energy wave and measure the reflection of the mechanical energy wave in structure 102 as the measured vibration reading.

Structure ground transducer 265 may be configured to "megger" structure ground 130. For example, structure ground transducer 265 may be configured measure a ground impedance of structure ground 130 at structure 102. Structure ground transducer 265 may send the measured ground impedance reading back to power line monitor 105. Insulator electromagnetic transducer 270 may be placed on or near insulator string 115, be configured to measure an electromagnetic profile of insulator string 115, and send the measured electromagnetic profile back to power line monitor 105.

From stage 510, where power line monitor 105 collects the plurality of status data, method 500 may advance to stage 520 where power line monitor 105 (or SCADA 400) may analyze the collected plurality of status data to determine when a one of the collected plurality of status data is outside of a normal operation range for a one of the plurality of components corresponding to the one of the collected plurality of status data. Consistent with embodiments of the invention, the collected plurality of status data may be trended and interpreted. This may include, but is not limited to, providing: i) trending of component data; ii) heuristic algorithms specific to each monitored component type, which may interpret real-time and trended data to determine if the component is degrading; and iii) comparison of algorithm outputs to alarm set points to determine estimation of effects of conditions on remaining component life.

For example, conductor splices and conductor dead-ends may deteriorate over time and may eventually fail. As they approach their failure point, they become hotter and hotter. Consequently, the temperature of conductor splice 125 and/or the conductor deadened may be compared to the temperature of conductor 110. If the temperature of conductor splice 125 and/or the temperature of the conductor deadened is greater than the temperature of conductor 110 by a predetermined amount, then the temperature of conductor splice 125 and/or the temperature of the conductor deadened may be considered to be out side of the normal operation range for conductor splice 125 and/or the conductor deadened.

As another example, conductor 110 may be prone to "galloping." Conductor galloping (sometimes called dancing), is a phenomenon where power line conductors move with large amplitudes. Galloping usually occurs when an unsteady, high or gusty wind blows over a conductor covered by a layer of ice deposited by freezing rain, mist, or sleet. The coating may vary from a very thin glaze on one side to a solid three-inch cover giving the conductor an irregularly shaped profile. Consequently, this ice covering may give the conductor a slightly out-of-round, elliptical, or quasi-airfoil shape. Wind blowing over this irregularly shaped profile results in aerodynamic lift that causes the conductor to gallop. The wind can be anything between 5 to 45 miles-per-hour at an angle to the power line of 10 to 90 degrees. The wind may be unsteady in velocity or direction. Consequently, the movement profile of conductor 110 may be periodically analyzed by conductor motion transducer 245, power line monitor 105, or SCADA 400 to see if the motion of conductor 110 is consistent with the galloping conductor phenomenon.

As another example, conductor 110 may be prone to damage through Aeolian vibration. Aeolian vibration is a high-frequency low-amplitude oscillation generated by a low velocity, comparatively steady wind blowing across a conductor. This steady wind creates air vortices or eddies on the lee side of the conductor. These vortices or eddies will detach at regular intervals from the top and bottom area of the conductor (i.e. "vortex shedding") creating a force on the conductor that is alternately impressed from above and below. If the frequency of the forces (i.e. expected excitation frequency) approximately corresponds to a frequency of a resonant vibration mode for a conductor span (i.e. natural frequency of the power line), the conductor will tend to vibrate in many loops in a vertical plane. The frequency of resonant vibration depends mainly on conductor size and wind velocity and is generally between 5 and 100 Hz for wind speeds within the range of 0 to 15 miles per hour. The peak-to-peak vibration amplitudes will cause alternating bending stresses great enough to produce fatigue failure in the conductor strands at the attachment points to the power line structure. Tensioned conductors in long spans are particularly subject to vibration fatigue. This vibration is generally more severe in flat open terrain where steady winds are more often encountered. Consequently, the vibration profile of conductor 110 may be periodically analyzed by conductor vibration transducer 250, power line monitor 105, or SCADA 400 to see if the vibration of conductor 110 is greater than acceptable levels or significantly different than a vibration profile taken at a previous time (e.g. when the power line including structure 102 was first constructed).

Insulator string 115 may be connected to structure 102 on insulator string support 120. Insulator string support 120, however, may weaken and loosen due to vibration. Damage to insulator string support 120 may be detectable through vibration or excessive motion. Consequently, the vibration profile of insulator string support 120 may be periodically analyzed by support vibration transducer 255, power line monitor 105, or SACADA 400 to see if the vibration of insulator string support 120 is greater than acceptable levels or significantly different than a vibration profile taken at a previous time (e.g. when the power line including structure 102 was first constructed).

Power line structures (e.g. structure 102), for example, may be made of concrete, wood, or steel. Regardless of the material, power line structures may deteriorate, for example, by rot, rust, corrode, or the bolts of a lattice structure may loosen. A level of deterioration can be determined by how structure 102 vibrates. Consequently, the vibration profile of structure 102 may be periodically analyzed by structure vibration transducer 260, power line monitor 105, or SCADA 400 to see if the vibration of structure 102 is greater than acceptable levels or significantly different than a vibration profile taken at a previous time (e.g. when the power line including structure 102 was first constructed).

Structure 102 may be grounded through structure ground 130. Structure ground 130 may comprise a ground rod or a series of ground rods being driven into the earth near structure 102. The ground rod or a series of ground rods are connect to structure 102 by a wire. While an impedance of structure ground 130 may have been checked and found acceptable (e.g. between 20 ohms and 40 ohms) when structure 102 was built, the grounding of structure 102 may deteriorate over time. Consequently, the impedance of structure ground 130 may be periodically analyzed by structure ground transducer 265, power line monitor 105, or SACADA 400 to see if the impedance of structure ground 130 is greater than a predetermined acceptable level or significantly different than an impedance of structure ground 130 taken at a previous time (e.g. when the power line including structure 102 was first constructed).

With power lines, conductors may be supported or terminated (e.g. dead-end) at structures where conductors may be electrical isolation via insulator strings. Insulator strings (e.g. insulator string 115) may fail either mechanically or electrically. Mechanical failures may be the result of physical damage to the "bells" or "core" of insulator string 115. Electrical failures may be the result of contamination and tracking that can be detected via corona or electromagnetic disruptions (e.g. like static on an AM radio). Accordingly, embodiments of the invention may use devices that measure corona or partial discharge that may detect insulator tracking. Consequently, the electromagnetic profile of insulator string 115 may be periodically analyzed by insulator electromagnetic transducer 270, power line monitor 105, or SCADA 400 to see if the corona or electromagnetic disruptions of insulator string 115 is greater than acceptable levels or significantly different than an electromagnetic profile taken at a previous time (e.g. when the power line including structure 102 was first constructed).

Once power line monitor 105 (or SCADA 400) analyzes the collected plurality of status data in stage 520, method 500 may continue to stage 530 where power line monitor 105 (or SCADA 400) may display results of the collected data analysis. The results may indicate that the one of the collected plurality of status data is outside of the normal operation range for the one of the plurality of components corresponding to the one of the collected plurality of status data as described above. After power line monitor 105 may display the results at stage 530, method 500 may then end at stage 540.

Embodiment of the present invention may, for example, be implemented using a memory, a processing unit, and other components. Any suitable combination of hardware, software, and/or firmware may be used to implement the memory, processing unit, or other components. The processing unit may implement program modules. Generally, consistent with embodiments of the invention, program modules may include routines, programs, components, data structures, and other types of structures that perform particular tasks or implement particular abstract data types.

Moreover, embodiments of the invention may be practiced with other computer system configurations, including hand-held devices, multiprocessor systems, microprocessor-based or programmable consumer electronics, minicomputers, mainframe computers, and the like. Embodiments of the invention may also be practiced in distributed computing environments where tasks are performed by remote processing devices that are linked through a communications network. In a distributed computing environment, program modules may be located in both local and remote memory storage devices.

Furthermore, embodiments of the invention may be practiced in an electrical circuit comprising discrete electronic elements, packaged or integrated electronic chips containing logic gates, a circuit utilizing a microprocessor, or on a single chip containing electronic elements or microprocessors. Embodiments of the invention may also be practiced using other technologies capable of performing logical operations such as, for example, AND, OR, and NOT, including but not limited to mechanical, optical, fluidic, and quantum technologies. In addition, embodiments of the invention may be practiced within a general purpose computer or in any other circuits or systems.

Embodiments of the invention, for example, may be implemented as a computer process (method), a computing system, or as an article of manufacture, such as a computer program product or computer readable media. The computer program product may be a computer storage media readable by a computer system and encoding a computer program of instructions for executing a computer process. The computer program product may also be a propagated signal on a carrier readable by a computing system and encoding a computer program of instructions for executing a computer process. Accordingly, the present invention may be embodied in hardware and/or in software (including firmware, resident software, micro-code, etc.). In other words, embodiments of the present invention may take the form of a computer program product on a computer-usable or computer-readable storage medium having computer-usable or computer-readable program code embodied in the medium for use by or in connection with an instruction execution system. A computer-usable or computer-readable medium may be any medium that can contain, store, communicate, propagate, or transport the program for use by or in connection with the instruction execution system, apparatus, or device.

The computer-usable or computer-readable medium may be, for example but not limited to, an electronic, magnetic, optical, electromagnetic, infrared, or semiconductor system, apparatus, device, or propagation medium. More specific examples (a non-exhaustive list) of the computer-readable medium would include the following: an electrical connection having one or more wires, a portable computer diskette, a random access memory (RAM), a read-only memory (ROM), an erasable programmable read-only memory (EPROM or Flash memory), an optical fiber, and a portable compact disc read-only memory (CD-ROM). Note that the computer-usable or computer-readable medium could even be paper or another suitable medium upon which the program is printed, as the program can be electronically captured, via, for instance, optical scanning of the paper or other medium, then compiled, interpreted, or otherwise processed in a suitable manner, if necessary, and then stored in a computer memory.

Embodiments of the present invention are described above with reference to block diagrams and/or operational illustrations of methods, systems, and computer program products according to embodiments of the invention. It is to be understood that the functions/acts noted in the blocks may occur out of the order noted in the operational illustrations. For example, two blocks shown in succession may in fact be executed substantially concurrently or the blocks may sometimes be executed in the reverse order, depending upon the functionality/acts involved.

While certain features and embodiments of the invention have been described, other embodiments of the invention may exist. Furthermore, although embodiments of the present invention have been described as being associated with data stored in memory and other storage mediums, aspects can also be stored on or read from other types of computer-readable media, such as secondary storage devices, like hard disks, floppy disks, or a CD-ROM, a carrier wave from the Internet, or other forms of RAM or ROM. Further, the steps of the disclosed methods may be modified in any manner, including by reordering stages and/or inserting or deleting stages, without departing from the principles of the invention.

While certain embodiments of the invention have been described, other embodiments may exist. While the specification includes examples, the invention's scope is indicated by the following claims. Furthermore, while the specification has been described in language specific to structural features and/or methodological acts, the claims are not limited to the features or acts described above. Rather, the specific features and acts described above are disclosed as example for embodiments of the invention.

## Claims

1. A method of providing maintenance monitoring, the method comprising:
collecting, by a power line monitor, a plurality of status data respectively corresponding to a plurality of components on a power line;
analyzing the collected plurality of status data to determine when a one of the collected plurality of status data is outside of a normal operation range for a one of the plurality of components corresponding to the one of the collected plurality of status data; and
displaying results of the collected data analysis, the results indicating that the one of the collected plurality of status data is outside of the normal operation range for the one of the plurality of components corresponding to the one of the collected plurality of status data.

2. The method of claim 1, wherein collecting the plurality of status data respectively corresponding to the plurality of components on a power line comprises collecting the one of the collected plurality of status data corresponding to the one of the plurality of components comprising a conductor splice, the one of the collected plurality of status data comprising a temperature of the conductor splice.

3. The method of claim 2, wherein analyzing the collected plurality of status data to determine when the one of the collected plurality of status data is outside of the normal operation range comprises determining that the temperature of the conductor splice is greater than a temperature of a conductor containing the splice by a predetermined amount.

4. The method of claim 1, wherein collecting the plurality of status data respectively corresponding to the plurality of components on a power line comprises collecting the one of the collected plurality of status data corresponding to the one of the plurality of components comprising a conductor dead-end, the one of the collected plurality of status data comprising a temperature of the conductor dead-end.

5. The method of claim 4, wherein analyzing the collected plurality of status data to determine when the one of the collected plurality of status data is outside of the normal operation range comprises determining that the temperature of the conductor dead-end is greater than a temperature of a conductor ending at the dead-end by a predetermined amount.

6. The method of claim 1, wherein collecting the plurality of status data respectively corresponding to the plurality of components on a power line comprises collecting the one of the collected plurality of status data corresponding to the one of the plurality of components comprising an insulator string, the one of the collected plurality of status data comprising an current electromagnetic profile of the insulator string.

7. The method of claim 6, wherein analyzing the collected plurality of status data to determine when the one of the collected plurality of status data is outside of the normal operation range comprises determining that the current electromagnetic profile of the insulator string is different from an initial electromagnetic profile of the insulator string taken at a previous time.

8. The method of claim 1, wherein collecting the plurality of status data respectively corresponding to the plurality of components on a power line comprises collecting the one of the collected plurality of status data corresponding to the one of the plurality of components comprising a support connecting an insulator string to a structure, the one of the collected plurality of status data comprising a current vibration profile of the support.

9. The method of claim 1, wherein collecting the plurality of status data respectively corresponding to the plurality of components on a power line comprises collecting the one of the collected plurality of status data corresponding to the one of the plurality of components comprising a structure, the one of the collected plurality of status data comprising a current structure vibration profile of the structure.

10. The method of claim 1, wherein collecting the plurality of status data respectively corresponding to the plurality of components on a power line comprises collecting the one of the collected plurality of status data corresponding to the one of the plurality of components comprising a ground of a structure, the one of the collected plurality of status data comprising a current impedance measurement of the ground of the structure.

11. The method of claim 1, wherein collecting the plurality of status data respectively corresponding to the plurality of components on a power line comprises collecting the one of the collected plurality of status data corresponding to the one of the plurality of components comprising a conductor, the one of the collected plurality of status data comprising a current conductor vibration profile of the conductor.

12. The method of claim 1, wherein collecting the plurality of status data respectively corresponding to the plurality of components on a power line comprises collecting the one of the collected plurality of status data corresponding to the one of the plurality of components comprising a conductor, the one of the collected plurality of status data comprising a movement profile of the conductor.

13. The method of claim 1, wherein collecting, by the power line monitor, the plurality of status data respectively corresponding to the plurality of components on the power line comprises collecting, by the power line monitor, the plurality of status data respectively corresponding to the plurality of components on the power line comprising one of the following: an electric transmission line and an electric distribution line.

14. A computer-readable medium that stores a set of instructions which when executed perform a method for providing maintenance monitoring, the method executed by the set of instructions comprising:
receiving, by a computer, a plurality of status data respectively corresponding to a plurality of components on a power line;
analyzing the collected plurality of status data to determine when a one of the collected plurality of status data is outside of a normal operation range for a one of the plurality of components corresponding to the one of the collected plurality of status data; and
displaying results of the collected data analysis, the results indicating that the one of the collected plurality of status data is outside of the normal operation range for the one of the plurality of components corresponding to the one of the collected plurality of status data.

15. A system for providing maintenance monitoring, the system comprising:
a power line monitor configured to collect a plurality of status data respectively corresponding to a plurality of components on a power line, the a plurality of components comprising at least two of the following: a structure, a conductor, a conductor splice, a conductor dead-end, an insulator string, a support connecting the insulator string to the structure, and a ground of the structure; and
a supervisory control and data acquisition (SCADA) system configured to;
receive the plurality of status data from the power line monitor,
analyze the collected plurality of status data to determine when a one of the collected plurality of status data is outside of a normal operation range for a one of the plurality of components corresponding to the one of the collected plurality of status data, and
display results of the collected data analysis, the results indicating that the one of the collected plurality of status data is outside of the normal operation range for the one of the plurality of components corresponding to the one of the collected plurality of status data.
